# EUROPEAN PATENT SPECIFICATION

(11) **EP 2 773 174 B1**
(45) Date of publication and mention of the grant of the patent: **19.09.2018**
(21) Application number: 12842798.6
(22) Date of filing: 11.10.2012
(51) Int. Cl.: H05K 13/02

(54) **TAPE FEEDER**
BANDZUFÜHRUNG
DISPOSITIF D'ALIMENTATION À BANDE

(30) Priority: 24.10.2011 JP 2011232439
(43) Date of publication of application: 03.09.2014
(73) Proprietor: Fuji Machine Mfg. Co., Ltd., Chiryu-shi Aichi 472-8686 (JP)
(72) Inventor: KUNIHIRO, Tsutomu, Chiryu-shi Aichi 472-8686 (JP); TAKADA, Yukinori, Chiryu-shi Aichi 472-8686 (JP); IMAI, Mitsuo, Chiryu-shi Aichi 472-8686 (JP)
(74) Representative: Grünecker Patent- und Rechtsanwälte PartG mbB
(86) International application number: PCT/JP2012/076320
(87) International publication number: WO 2013/061791

(56) References cited:
- DE-A1- 19 529 533
- JP-A- 2007 242 757
- JP-A- 2009 246 403
- JP-A- 2010 147 148
- JP-A- 2010 219 107
- US-A- 5 995 877

## Description

### TECHNICAL FIELD

The present invention relates to a tape feeder which supplies electronic components to a specific position by indexing taped components.

### BACKGROUND TECHNOLOGY

Tape feeders are usually equipped with a holder for holding taped components in a wound state, a taped component path for guiding taped components pulled out from the holder, and an indexing device for indexing the taped components; with a configuration to supply the electronic components to the supply position. Also, in recent years, it is required to make possible the supply of many types and quantities of electronic components, and, as disclosed in the Prior Art below, there are many tape feeders configured such that 1 tape feeder is equipped with multiple holders with multiple taped components being guided to multiple supply positions using multiple taped component paths.

Prior Art 1: Japanese Unexamined Patent Application Publication Number 2011-138834

The document JP 2009-246 403 A discloses a feeder tape supply device having a plurality of feeders storing electronic circuit part articles. Said plurality of feeders are arranged in one row. A supply part is provided for supplying tapes with said electronic circuit part articles to a supply position. The feeder tape supply device is controlled by means of an operation panel.

### BRIEF SUMMARY OF THE INVENTION

### PROBLEM SOLVED BY INVENTION

Tape feeders with a configuration for indexing multiple taped components pulled out inside multiple taped component paths using multiple indexing devices are known as dual lane feeders, triple lane feeders and so on, and are able to supply many quantities and types of electronic components. In many cases tape feeders equipped with multiple supply lanes such as this are individually equipped with multiple control switches for individually controlling supply lanes, or in other words, taped components pulled out inside taped component paths, based on the multiple supply lanes. For each of these multiple individual control switches, when recognizing which supply lane a switch corresponds to from among the multiple supply lanes, it is desirable for intuitive recognition to be possible; if intuitive recognition is possible, it is possible to improve switch usability. The present invention, taking account of the situation outlined above, is a proposal for a tape feeder equipped with multiple supply lanes, for which intuitive recognition is possible of which individual control switches which correspond to those multiple supply lanes correspond to which supply lane.

### MEANS OF SOLVING THE PROBLEM

This object is solved by the features of claim 1.

Further improvements are laid down in the sub-claims.

The tape feeder from Claim 1 of this application is configured such it is equipped with: each of multiple holders for holding taped components in a wound state in which electronic components are stored in multiple cavities formed in the carrier tape; for each of those multiple holders, each of multiple taped component paths for guiding the taped components pulled out from the corresponding holder from among the multiple holders to an electronic component supply position; for each of these multiple taped component paths, each of multiple indexing devices for indexing the taped
components pulled out from the corresponding taped component path from among the multiple taped component paths to the supply position; and an operation panel on which (a) as well as multiple individual control switches for controlling individually the corresponding item from the multiple taped components for each of the multiple taped components pulled out from the multiple taped component paths (b) multiple symbols are displayed to indicate to which item each of those multiple individual switches corresponds from the multiple taped components; with these multiple symbols being displayed on the operation panel in the same pattern as the arrangement pattern of the multiple supply positions.

Further, the tape feeder, is configured such that as well as the multiple supply positions being arranged parallel to each other and along multiple straight lines extending in a perpendicular direction to the indexing direction of the taped components, they are arranged so that they are not overlapping in the indexing direction of the taped components.

Also, the tape feeder from Claim 2, for the tape feeder from Claim 1, is configured such that the multiple individual control switches are arranged on the operation panel in a different pattern to the arrangement pattern of the multiple supply positions.

### EFFECTS OF THE INVENTION

On the tape feeder from Claim 1, multiple symbols for indicating which individual control switch to which item among the multiple taped components are displayed on the operation panel, and those multiple symbols are displayed in the same pattern as the arrangement pattern of the multiple supply positions. By this, for the operator, it is possible to intuitively connect the electronic component supply position and individual control switch and it is possible to intuitively recognize which individual control switch corresponds to which supply lane.

Also, for the tape feeder from Claim 2, the multiple supply positions, as well as being arranged along parallel multiple straight lines, are such that they are not overlapping in the perpendicular direction to those multiple straight lines. In other words. The multiple supply position are not arranged in a grid. For the multiple symbols used to indicate to which one of the multiple taped components an individual control switch corresponds, there are many cases in which they are displayed in a grid on the operation panel; if the multiple supply positions are arranged in a grid, it is relatively easy to link those multiple supply positions arranged in a grid with the multiple symbols displayed in a grid. However, it is difficult to link multiple symbols displayed in a grid with multiple supply positions not arranged in a grid. As such, on the tape feeder from Claim 2, it is possible to thoroughly realize the effects of displaying multiple symbols on the operation panel in the same pattern as the arrangement pattern of the multiple supply positions.

Also, on the tape feeder from Claim 3, the multiple individual switches are arranged on the operation panel in a pattern different to the arrangement pattern of the multiple supply positions. In the case that the multiple symbols are displayed on the operation panel in the same pattern as the arrangement pattern of the multiple supply positions, it may be presumed that the multiple individual control switches are also arranged on the operation panel in the same pattern as the arrangement pattern of the multiple supply positions. However, if the multiple symbols and individual control switches are displayed or arranged in the same arrangement pattern as multiple supply positions not arranged in a grid, as described in detail below, the display or arrangement area for 1 symbol and the individual control switch which corresponds to that symbol are not positioned in a grid. Due to this, there is an issue of making the operation panel on which multiple of those areas are arranged larger. As such, as for the tape feeder from Claim 3, if the multiple individual control switches are, conversely, arranged in a different pattern to the arrangement pattern of the multiple supply positions, it becomes possible to position multiple of the above areas in a grid. By this, it is possible to curtail the operation panel being made bigger.

### BRIEF DESCRIPTION OF THE DRAWINGS

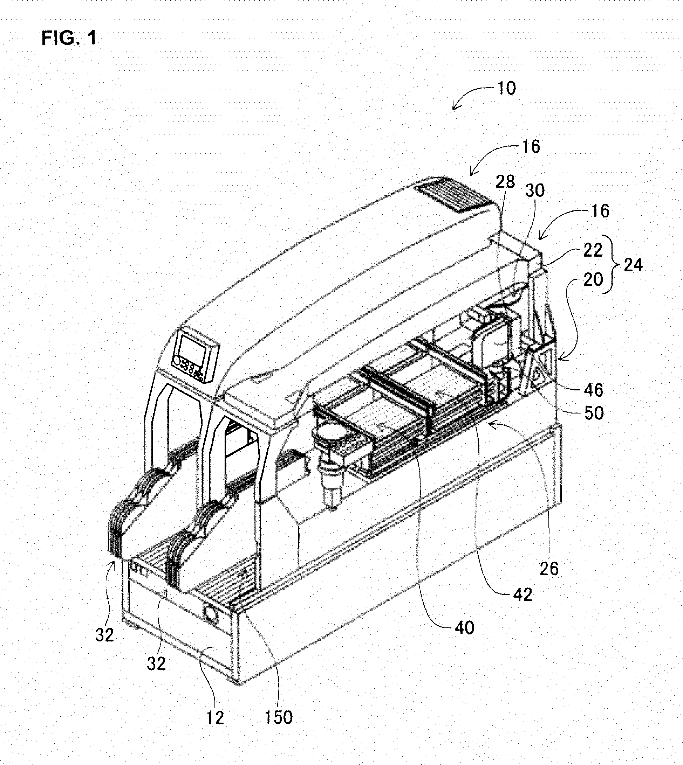

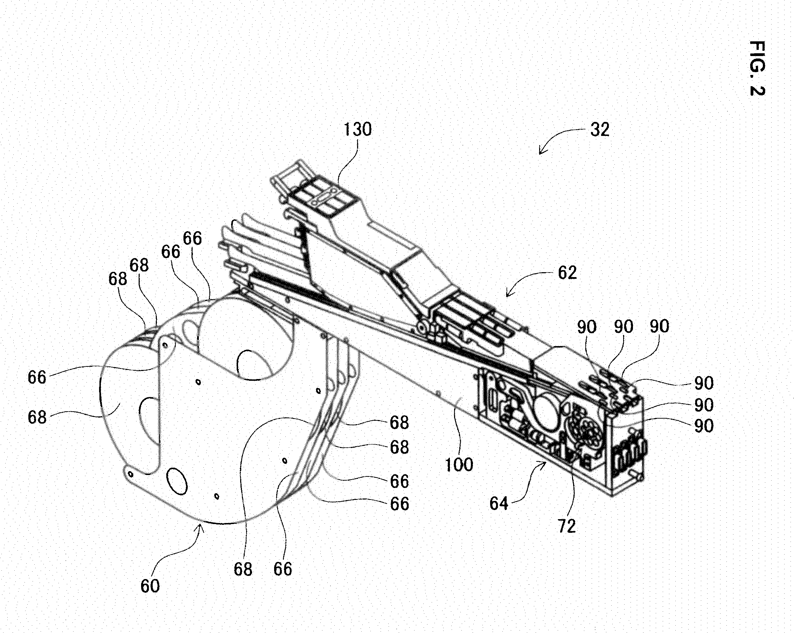

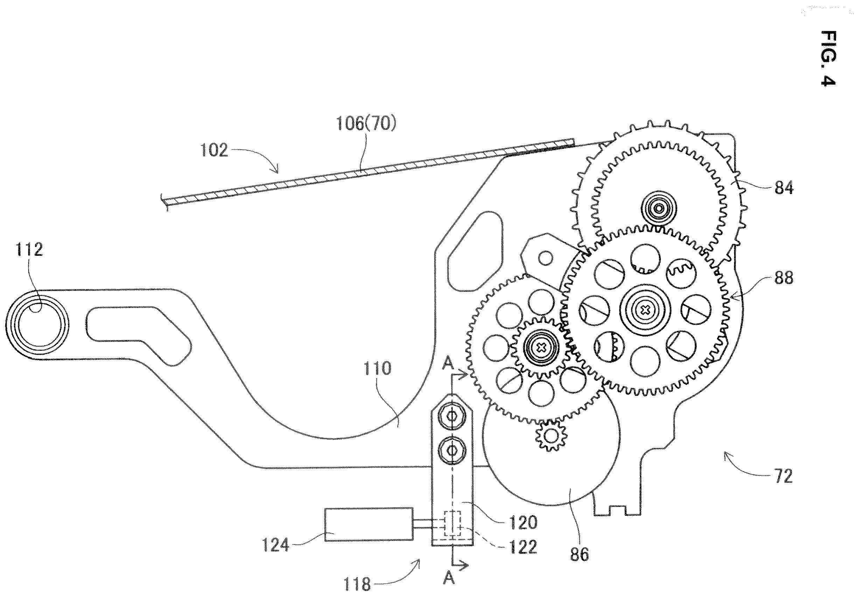

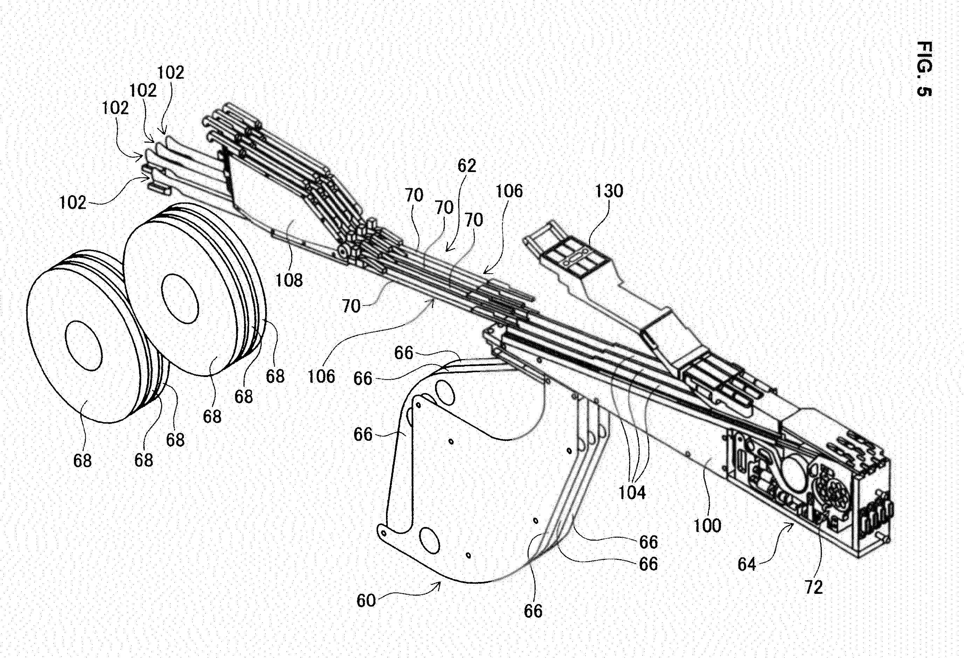

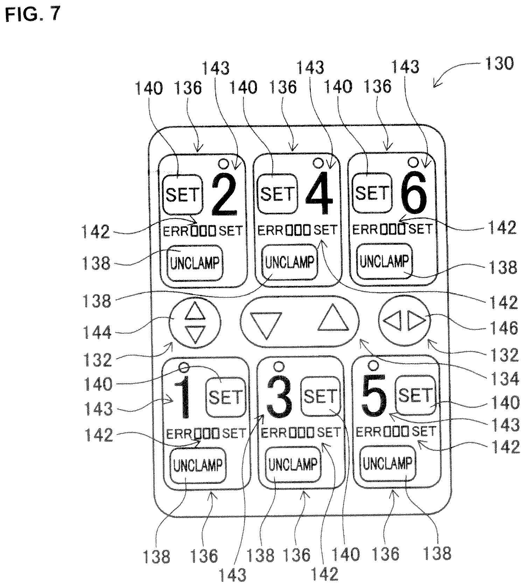

[FIG. 1]
   This is a perspective view showing an electronic component mounter machine configured from 2 electronic component mounters arranged side by side to which tape feeders of the embodiment of the present invention are attached.
[FIG. 2]
   This is a perspective view of a tape feeder shown in FIG. 1.
[FIG. 3]
   This is a top view showing a section of the tape feeder shown in FIG. 2 and taped components indexed by that electronic component supply device.
[FIG. 4]
   This is a schematic drawing showing the indexing device inside the tape feeder shown in FIG. 2.
[FIG. 5]
   This is a perspective view showing the tape feeder shown in FIG. 2 with the feeder main body and sliding sections separated.
[FIG. 6]
   This is a cross-section of line AA shown in FIG. 4.
[FIG. 7]
   This is a schematic drawing showing the operation panel which is equipped on the tape feeder shown in FIG. 2 and FIG. 5.
[FIG. 8A]
   This is a schematic drawing showing the supply positions of the electronic components on the tape feeder shown in FIG. 2 and FIG. 5.
[FIG. 8B]
   This is a schematic drawing of the operation panel shown in FIG. 7.
[FIG. 9]
   This is a schematic drawing showing a comparative example of an operation panel.
[FIG. 10A]
   This is a schematic drawing showing an example of the supply positions the electronic components on the tape feeder.
[FIG. 10B]
   This is a schematic drawing showing an example of an operation panel of the tape feeder.

### PREFERRED EMBODIMENT FOR CARRYING OUT THE INVENTION

The following describes in detail referring to the figures, as an embodiment for carrying out the present invention, an example embodiment for the present invention.

### Electronic component mounter machine configuration

Electronic component mounter machine (hereafter in some cases abbreviated to "mounter machine") 10 is shown in FIG. 1. That figure is perspective view with some sections of the external parts of mounter machine 10 omitted. Mounter machine 10 is configured including 1 system base 12 and 2 electronic component mounter modules (hereafter in some cases abbreviated to "mounter module") 16 arranged lined up side by side adjacent to each other on that system base 12, and is used to perform the mounting work of electronic components on a circuit board. For the description below, the direction in which mounter modules 16 are lined up side by side is referred to as the X-axis direction and the horizontal direction perpendicular to that direction is the Y-axis direction.

Each mounter module 16 equipped on mounter machine 10 comprises, mainly, mounter module main body 24 configured including frame 20 and beam 22 mounted above that frame 20; conveyance device 26 for conveying circuit boards in the X-axis direction as well as securing them in a specified position; mounting head 28 for mounting electronic components on the circuit board secured by the conveyance device 26; moving device 30 for moving mounting head 28 attached to beam 22 in the X-axis direction and Y-axis direction; and supply device 32 for supplying electronic components to mounting head 28 positioned at the front of frame 20.

Conveyance device 26 comprises 2 conveyor devices 40 and 42 and those 2 conveyor devices 40 and 42 are positioned in the center of the Y-axis direction of frame 20 so that they are parallel to each other and extend in the X-axis direction. Each of the 2 conveyor devices 40 and 42, as well as conveying circuit boards held by conveyor devices 40 and 42 in the X-axis direction using an electromagnetic motor (omitted from figure), are configured to hold circuit boards securely in a specified position.

Moving device 30 is an XY robot type moving device, and comprises an electromagnetic motor (omitted from figure) for sliding slider 46 which holds mounting head 28 in the X-direction; and an electromagnetic motor (omitted from figure) for sliding in the Y-direction; by operating these 2 electromagnetic motors, it is possible to move mounting head 28 to any position.

Also, mounting head 28 is for mounting electronic components on a circuit board held by conveyor device 26, and has suction nozzles 50 on its lower side for picking up circuit components. Suction nozzles 50 are configured with paths for negative air pressure and positive air pressure from a positive and negative air pressure supply device (omitted from figure) to pass through, with the electronic components being held by suction based on negative pressure, and with the electronic components which are being held being released by supplying a small amount of positive pressure.

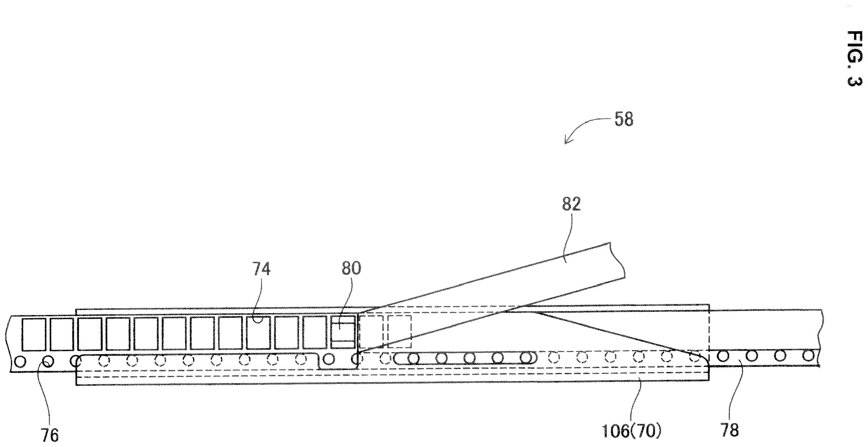

Supply device 32 is positioned on the front end of frame 20 and is a feeder type supply device, in other words, a tape feeder. Tape feeder 32 is configured to supply consecutively circuit components from taped components 58 (refer to FIG. 3) which are components that have been taped to the supply position for mounting head 28, and, as shown in FIG. 2, is configured from holder 60 for holding taped components in a wound state, path 62 for guiding taped components 58 pulled out from holder 60 to an electronic component supply position, and moving section 64 for indexing taped components 58 to a supply position.

Holder 60 has 6 reel holders 66 and can hold 6 reels 68 on which taped components 58 are wound. 6 reel holders 66 are positioned in 2 rows of 3, and 3 reel holders 66 are positioned diagonally above 3 reel holders 66. Also, path 62 has 6 taped component paths (refer to FIG. 5) 70 for the 6 reel holders 66; and each path 70 is configured to guide taped components 58 pulled out from the reel holder 66 corresponding to that path to the electronic component supply position. And, moving section 64 has 6 indexing devices (only 1 is shown in the figures) 72 corresponding to the 6 taped component paths; and each indexing device 72 is configured to index taped components 58 pulled out from the taped component path 70 corresponding to that device to the electronic component supply position.

Specifically, taped components 58 are configured from, as shown in FIG. 3, carrier tape 78 formed with multiple storage cavities 74 and indexing holes 76 at the same pitch; electronic components 80 stored in storage cavities 74; and top cover tape 82 covering storage cavities 74 in which are stored electronic components 80 of carrier tape 78. And, taped components 58 with top cover tape 82 in an affixed state to this carrier tape 78 are pulled out and extended from taped component path 70. Also, indexing device 72, as shown in FIG. 4, is configured from sprocket 84 which engages with the indexing holes 76 formed in carrier tape 78 of taped components 58; electromagnetic motor 86; and transmission device 88 for transmitting the rotational power of that electromagnetic motor 86 to sprocket 84.

By this configuration, by operating electromagnetic motor 86 of indexing device 72, taped components 58 with top cover tape 82 in an affixed state to carrier tape 78 are indexed using sprocket 84 by the same pitch as the pitch formed by storage cavities 74. And, top cover tape 82 is peeled away from carrier tape 78 using a peeling device (omitted from figures). By this, circuit components 80 stored in storage cavities 74 are revealed consecutively, and those revealed electronic components 80 stored in storage cavities 74 are removed by suction nozzles 50.

Also, the position to which circuit components 80 are supplied is the end section of taped components path 70, in other words, the end of the side to which taped components 58 of taped components path 70 are indexed; the supply position of electronic components 80 for the 6 taped components path 70, in other words, the 6 supply positions 90 are, as shown in FIG. 2, positioned in 2 rows of 3 each; with the arrangement direction of those 3 supply positions 90 and the arrangement direction of the other 3 supply positions 90 respectively parallel extending in the X-axis direction. Furthermore, the gaps between supply positions 90 in each row are all the same. Also, the 6 supply positions 90 are offset in the Y-axis direction; and for the Y-axis direction, in other words, the indexing direction of taped components 58, the multiple supply positions 90 are such that they do not overlap.

Also, tape feeder 32, as shown in FIG. 5, is such that multiple indexing devices 72 inside feeder main body 100 and 6 slide material 102 can be separated; and by sliding each slide material 102 in a state engaged with each of the 6 T-grooves formed in feeder main body 100, it is possible for them to be removably attached to feeder main body 100. Each slide material 102 is configured from a long plate type path forming section 106 formed on the upper surface of taped component path 70 and top cover tape storage section 108 equipped on the approximate center of the long side of that path forming section 106; and by path forming section 106 being engaged with T-groove 104, it can be attached to feeder main body 100. And, each slide material 102 is configured such that, when in a state attached to feeder main body 100, it is held so that it is possible to index taped component path 70, in other words, taped components 58 pulled out from the upper surface of path forming section 106, to supply position 90. Also, top cover tape storage section 108 is an item that stores top cover tape 82 peeled away from carrier tape 78. Also, 6 reel holders 66 are secured to the underside of the end of the side opposite to the side of feeder main body 100 with indexing device 72 inside.

Device 72 for indexing taped components 58 held in slide material 102 which is in an attached state to feeder main body 100 is inside feeder main body 100, and, as shown in FIG. 4, is secured to bracket 110 which is movable around an axis within feeder main body 100. Bracket 110 is attached at an axis to feeder main body 100 at axis hole 112 formed in the end of the opposite side to the side to which indexing device 72 is secured; and is biased in a counterclockwise direction in the figure using an elastic body which is omitted from the figure. In other words, indexing device 72 is biased upwards. By this, sprocket 84 of indexing device 72 is engaged with indexing holes 76 formed in carrier tape 78 of taped components 58, and it is possible to index taped components 58.

Also, as given above, slide material 102 is such that it can be removed from feeder main body 100, and when removing slide material 102 from feeder main body 100, it is necessary to release the engagement of indexing holes 76 of carrier tape 78 with sprocket 84 of indexing device 72. For this, feeder main body 100 is equipped with releasing mechanism 118 for releasing that engagement.

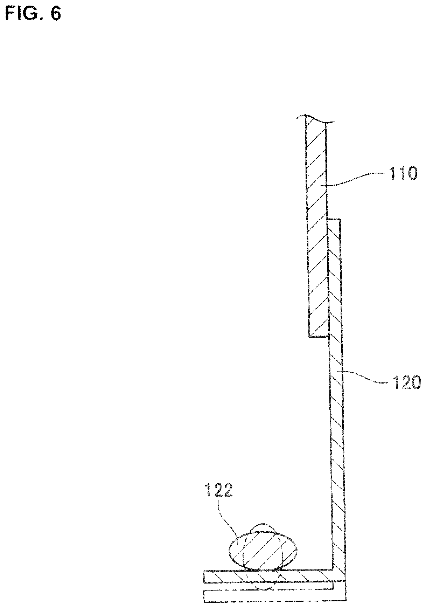

Releasing mechanism 118, as shown in FIG. 6 which is a cross-section view of line AA from FIG. 4, is configured from arm 120 which is bent into an approximate L-shape; elliptical cam 122 which is positioned such that it is possible to contact the upper surface of the bent section of that arm 120; and electromagnetic motor 124 (refer to FIG. 4) which rotates that cam 122. Arm 120 is secured to bracket 110 by the top end section, and engagement of taped components 58 with sprocket 84 can be released by moving bracket 110 in a clockwise direction in FIG. 4 by the rotation position of cam 122.

To describe in detail, as shown by the solid line in FIG. 6, when the position of cam 122 is such that the transverse diameter of elliptical cam 122 extends in the horizontal direction, arm 120 is not moved upwards by cam 122; and sprocket 84 secured to bracket 110 is biased upwards by the elastic force. By this, the engagement of taped components 58 with sprocket 84 is maintained. And, as shown by the 2-point dashed line in FIG. 6, if cam 122 is rotated so that the transverse diameter of elliptical cam 122 extends in the vertical direction, arm 120 is moved upwards by cam 122; and sprocket 84 secured to bracket 110 is moved down against the elastic force. By this, the engagement of taped components 58 with sprocket 84 is released, and it is possible to removed slide material 102 from feeder main body 100.

Operation of this releasing mechanism 118 is performed by an operation switch positioned on operation panel 130 on the upper surface of feeder main body 100. Arranged on this operation panel 130, as shown in FIG. 7, are selection switches 132 for selecting 1 of the 6 slide materials 102, and selection control switch 134 for controlling slide material 102 selected by the selection switch 132; and it is also equipped with individual control switch areas 136 in which are arranged multiple switches which correspond individually to the 6 slide materials 102.

Individual control switch areas 136 are 6 divided areas corresponding to the 6 slide materials 102, and unclamp switch 138, set switch 140, and display light 142 are arranged in each area. Unclamp switch 138 is an item for operating release mechanism (118), and by being pushed the engagement of taped components 58 with sprocket 84 is released. In other words, when removing slide material 102 from feeder main body 100, this unclamp switch 138 is operated. Furthermore, when attaching slide material 102 to feeder main body 100, by sliding path forming section 106 of slide material 102 in an engaged state with T-groove 104 of feeder main body 100, releasing mechanism 118 is released, in other words, the upward movement of arm 120 due to cam 122 is released. By this, taped components 58 are engaged with sprocket.

Also, set switch 140 is an item operated when slide material 102 is set on feeder main body 100 and is an item for confirming the attachment of slide material 102 on feeder main body 100. Display light 142 is an item for displaying the operation condition and such of slide material 102. In addition, in individual control switch areas 136, to judge which among the 6 slide materials 102 that individual control switch area 136 corresponds to, one of numeric characters 143 out of 1 to 6 is displayed. Specifically, positioned on the reel holder 66 side of tape feeder 32, from the viewpoint of the operator operating operation panel 130, in order from slide material 102 positioned on the furthest left, in other words, slide material positioned in the control switch area 1 36 on which "5" is displayed, and individual control switch area 136 on which "6" is displayed.

Also, selection switches 132 are configured from 2 types of switch, up/down direction selection switch 144 and left/right direction selection switch 146. Up/down direction selection switch 144 is an item for selecting one of slide materials 102 corresponding to individual control switch areas (individual control switch areas on which "2", "4", "6" is displayed) 136 positioned on the upper level of operation panel 130, and slide materials 102 corresponding to individual control switch areas (individual control switch areas on which "1", "3", "5" is displayed) 136 positioned on the lower level. Also, left/right direction selection switch 146 is an item for selecting one of slide materials 102 corresponding to individual control switch areas (individual control switch areas on which "1", "2", is displayed) 136 positioned on the left side of operation panel 130, slide materials 102 corresponding to individual control switch areas (individual control switch areas on which "5", "6", is displayed) 136 positioned on the right side, and slide materials 102 corresponding to individual control switch areas (individual control switch areas on which "3", "4", is displayed) 136 positioned between those. In other words, for example, when selecting slide material 102 corresponding to individual control switch selection area on which "2" is displayed, push the up arrow on up/down direction selection switch 144 and push the left arrow on left/right direction selection switch 146 once or twice.

Selection control switch 134 is an item for confirming the movement of taped components 58 held in slide material 102 selected by selection switches 132. Specifically, after slide material 102 is selected by the above selection switches 132, if the up arrow of selection control switch 134 is pushed, taped components 58 being held in the selected slide material 102 are indexed towards supply position 90. Also, if the down arrow of selection control switch 134 is pushed, taped components 58 being held in the selected slide material 102 are wound in the opposite direction of that towards supply position 90. By this, it is possible to confirm the movement of taped components 58 and it is possible to perform such as fine adjustment of the position of taped components 58 and confirmation of the movement of taped components 58 when a problem occurs.

Also, tape feeder 32 can be attached to and removed from feeder loading table 150 which is fixedly attached on the end section of the front of frame 20 of work machine 16. Feeder loading table 150 is configured from a slide section (omitted from figures) formed on the upper surface of frame 20 of work machine 16 extending in the Y-axis direction and an assembly surface section (omitted from figures) assembled on a side close to conveyance device 26 of the slide section; and the slide section can be slid in state with the underside edge section of feeder main body 100 of tape feeder 32 engaged. By this, the side wall surface of the side of the direction in which taped components were indexed on feeder main body 100 can be attached to the assembly surface section and tape feeder 32 can be attached to feeder loading table 150.

Due to configuration given above, tape feeder 32 can store up to 6 taped components 58 and can supply electronic components from each of those 6 taped components 58 to 6 supply positions 90. And, by removing that feeder 32 from feeder loading table 150 and attaching a different tape feeder 32, it is possible to exchange 6 taped components 58 with 1 feeder exchange. In addition, because with this tape feeder 32, each of the 6 slide materials 102 can be attached to and removed from feeder main body 100, by removing 1 slide material 102 from feeder main body 100 and attaching a different slide material 102, it is possible to also exchange only 1 taped component 58.

When exchanging slide materials 102, as given above, by operating unclamp switch 138 on individual control switch area 136, the engagement of taped components 58 with sprocket 84 is released, but there are 6 of these unclamp switches 38 equipped, corresponding individually to the 6 slide materials 102. Due to this, when exchanging slide materials 102, it is necessary to operate the unclamp switch 138 which corresponds to the slide material 102 you want to exchange, and it is preferable to be able to judge immediately which one of the 6 unclamp switches 138 corresponds to the slide material 102 that you want to exchange.

For this, on operation panel 130 of the present tape feeder 32, switches arranged in individual control switch area 136, specifically, unclamp switch 138 and set switch 140 have displayed on them, in order to judge to which one of the 6 slide materials 102 that they correspond, numeric character 143 from 1 to 6; and those 6 numeric characters 143 are displayed in the same pattern as the arrangement pattern of the 6 supply positions 90 of the 6 slide materials 102.

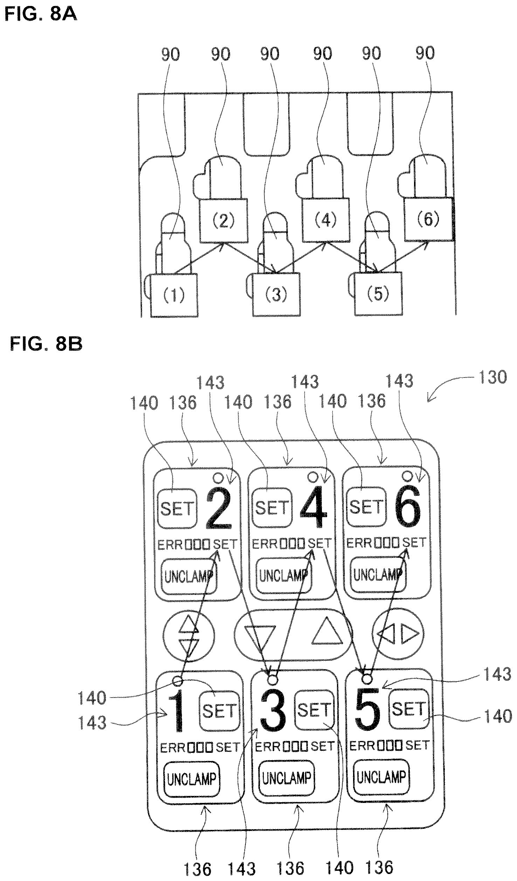

To describe specifically, the 6 supply positions 90 of the 6 slide materials 102, as shown in FIG. 8A, are arranged in 2 rows of 3 each and are positioned along 2 straight lines extending in a perpendicular direction to the indexing direction of taped components 58. And, the 6 supply positions 90 are such that they do not overlap in the indexing direction of taped components 58. Also, the 6 numeric characters 143 displayed on the operation panel, as shown in FIG. 8B, are also arranged in 2 rows of 3 each and positioned along 2 straight lines extending in a direction parallel to the up/down edge of operation panel 130. And, the 6 numeric characters 143 are such that they do not overlap in a direction perpendicular to the numeric character arrangement direction. Also, the numeric characters in FIG. 8A are items which are displayed so that it is easy to understand to which one of the 6 slide materials 102 each supply position 90 corresponds, are they are not, of course, given on the actual supply positions 90.

If those 6 supply positions 90 are joined by arrows in order from (1) to (6), the arrows are bent in a zig-zag, with arrows pointing diagonally up and right, and arrows pointing diagonally right and down, being repeated. Also, the 6 numeric characters 143 are joined by arrows in order from 1 to 6, the arrows are bent in a zig-zag, with arrows pointing diagonally up and right, and arrows pointing diagonally right and down, being repeated. In this way, the 6 numeric characters 143 are displayed in the same pattern as the arrangement pattern of the 6 supply positions 90 of the 6 slide materials 102. In other words, the 6 numeric characters 143, are displayed following the same regularity as the arrangement regularity of the 6 supply positions 90. By this, for operators, it is possible to intuitively recognize and possible to judge immediately which switch positioned in individual control switch area 136 on which each numeric character 143 is displayed corresponds to which one of the 6 slide materials 102.

Also, the 6 set switches 140 corresponding to the 6 slide materials 102 are arranged in a different pattern to the arrangement pattern of the 6 supply positions 90. This is because, in order to judge to which one of the 6 slide materials 102 to which set switch 140 applies, it is fine to make use of the numeric character 143 displayed next to that switch, so there is a low necessity to also arrange set switches 140 in the same arrangement pattern as supply positions 90. This is also because, if set switches 140 are arranged in a pattern the same as the arrangement pattern of supply positions 90, individual control switch areas 136 cannot be arranged in a grid and operation panel 130 becomes bigger.

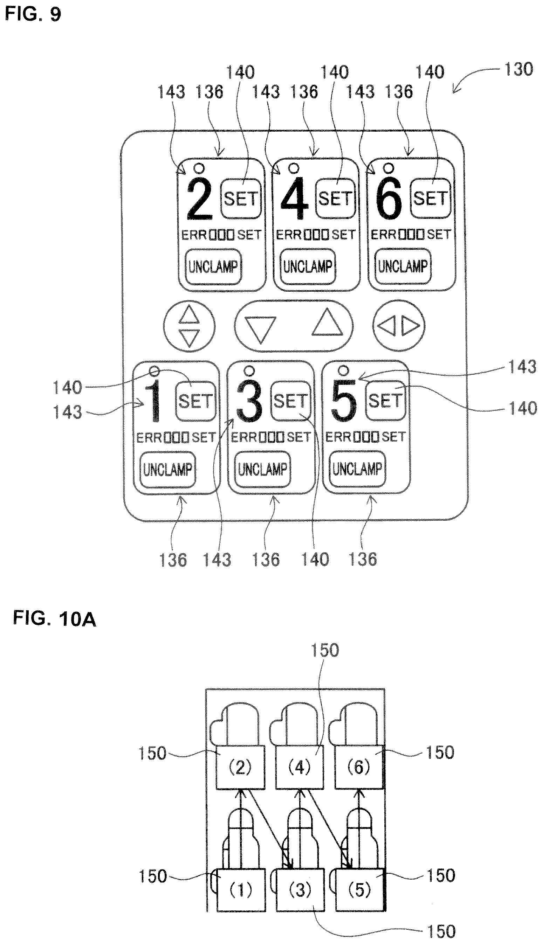

Specifically, for example, if set switches 140 and numeric characters 143 are displayed in the same pattern are the arrangement pattern of supply positions 90, as shown in FIG. 9, the position of the upper level individual control switch areas 136 and the position of the lower level individual control switch areas 136 and offset in the left-right direction, and operation panel 130 becomes bigger in the left-right direction. In order to avoid this, on the operation panel of the present tape feeder 32, by switching the arrangement position of set switch 140 and the display position of numeric character 143 of individual control switch areas 136 positioned on the top level, set switches 140 are arranged in a different pattern to the arrangement pattern of supply positions 90 and the 6 individual control switch areas 136 are arranged in a grid. By this, it is possible to design a smaller operation panel 130.

Also, for the example embodiment above, tape feeder 32 is one example of a tape feeder, and reel holder 66, taped component path 70, and indexing device 72 configured on tape feeder 32 are one example of a holder, taped component path, and indexing device. Also, operation panel 130 is one example of an operation panel, numeric characters 143 displayed on that operation panel 130, and unclamp switches 138 and set switches 140 arranged on operation panel 130, are one example of a symbol and individual control switches.

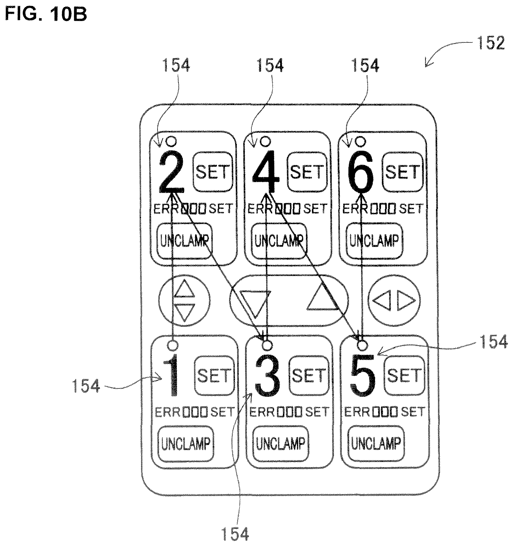

Furthermore, the present invention is not limited to the above example embodiment, and various changed or improved methods of embodiment are possible based on the knowledge of someone skilled in the art. Furthermore, in the above example embodiment, as well as supply positions 90 being arranged along 2 straight lines extending in a direction perpendicular to the indexing direction of taped components 58, they are such that they do not overlap in the indexing direction of taped components 58. An example which does not form part of the invention is shown in FIG. 10A and in FIG. 10B, where supply positions 150 are arranged overlapping in the indexing direction of taped components 58. In this example the supply positions 150 are arranged on the intersections between multiple straight lines extending in the indexing direction of taped components 58 and multiple straight lines perpendicular to those straight lines. In addition, to put it another way, it is acceptable to arrange them in a grid. The numeric characters 154 displayed on operation panel 152 which should correspond to supply positions 150 arranged this way in a grid, as shown in FIG. 10B, are arranged in a grid. By this, for this operation panel 152 also, in the same way as for operation panel 130 given above, it is possible for the operator to intuitively recognize which switches positioned on individual control switch areas 136 correspond to which slide materials 102.

### SYMBOL DESCRIPTIONS

32. Tape feeder; 66. Reel holder (holder); 70. Taped component path; 72. Indexing device (indexing device); 90. Supply position; 130. Operation panel; 138. Unclamp switch (individual control switch); 140. Set switch (individual control switch); 143. Numeric character (symbol); 150. Supply position; 152. Operation panel; 154. Numeric character (symbol)

## Claims

1. A tape feeder configured such that it is equipped with: multiple holders (60) for holding taped components (58) in a wound state in which electronic components (80) are stored in multiple cavities (74) formed in the carrier tape (78);
for each of those multiple holders (60), there is a respective taped component path (70) for guiding said taped components (58) pulled out from the corresponding holder (60) from among said multiple holders (60) to an electronic component supply position (90), said multiple supply positions (90) being arranged parallel to each other and along multiple straight lines extending in a perpendicular direction to the indexing direction of said taped components (58) as well as not overlapping in the indexing direction of said taped components (58);
for each of these multiple taped component paths (70), there is a respective indexing device (72) for indexing said taped components (58) pulled out from the corresponding taped component path (70) from among said multiple taped component paths (70) to said supply position (90 and
an operation panel (130) on which are arranged:
a) multiple individual control switches (138, 140) for controlling individually the corresponding item among the multiple taped components (58) pulled out from said multiple taped component paths (70) and
b) multiple symbols (143) are displayed to indicate to which item each of those multiple individual control switches (138, 140) corresponds among said multiple taped components (58); with said multiple symbols (143) being displayed on said operation panel (130) in the same pattern as the arrangement pattern of said multiple supply positions (90).

2. The tape feeder according to Claim 1, wherein said multiple individual control switches (138, 140) and symbols (143) are arranged in multiple individual control switch areas (136), which are arranged in a grid on said operation panel (130).

## Patentansprüche

1. Bandzuführeinrichtung, die derart konfiguriert ist, dass sie ausgestattet ist mit: zahlreichen Haltern (60) zum Halten von mit einem Band versehenen Bauteilen (58) in einem gewickelten Zustand, in dem elektronische Bauteile (80) in zahlreichen in dem Trägerband (78) ausgebildeten Hohlräumen (74) aufgenommen sind; wobei
es für jeden dieser zahlreichen Halter (60) einen entsprechenden Pfad (70) für die mit Band versehenen Bauteile gibt, um die mit Band versehenen Bauteile (58) zu führen, die aus dem entsprechenden Halter (60) der zahlreichen Halter (60) zu einer Elektronikbauteil-Zuführposition (90) gezogen werden, wobei die zahlreichen Zuführpositionen (90) parallel zueinander und entlang zahlreicher gerader Linien angeordnet sind, die sich in einer senkrechten Richtung zu der Indexierungsrichtung der mit Band versehenen Bauteile (58) erstrecken und sich in der Indexierungsrichtung der mit Band versehenen Bauteile (58) nicht überlappen;
es für jeden dieser zahlreichen Pfade (70) für die mit Band versehenen Bauteile eine jeweilige Indexierungsvorrichtung (72) zum Indexieren der mit Band versehenen Bauteile (58) gibt, die aus dem entsprechenden Pfad (70) für die mit Band versehenen Bauteile aus den zahlreichen Pfaden (70) für die mit Band versehenen Bauteile zu der Zuführposition (90) herausgezogen werden, und
ein Bedienfeld (130), auf dem angeordnet sind:
a) zahlreiche einzelne Steuerschalter (138, 140) zum individuellen Steuern des entsprechenden Gegenstands aus den zahlreichen mit Band versehenen Bauteilen (58), die aus den zahlreichen Pfaden (70) für die mit Band versehenen Bauteile gezogen werden, wobei
b) zahlreiche Symbole (143) angezeigt werden um zu kennzeichnen, welchem Gegenstand jeder dieser zahlreichen einzelnen Steuerschalter (138, 140) aus den zahlreichen mit Band versehenen Bauteilen (58) entspricht; wobei die zahlreichen Symbole (143) auf dem Bedienfeld (130) in demselben Muster wie das Anordnungsmuster der zahlreichen Zuführpositionen (90) angezeigt werden.

2. Bandzuführgerät nach Anspruch 1 bei dem die zahlreichen einzelnen Steuerschalter (138, 140) und Symbole (143) in zahlreichen einzelnen Steuerschaltbereichen (136) angeordnet sind, die in einem Raster auf dem Bedienfeld (130) angeordnet sind.

## Revendications

1. Dispositif d'alimentation à bande conçu de manière à être équipé de multiples supports (60) permettant de maintenir des composants sur bande (58) dans un état enroulé dans lequel des composants électroniques (80) sont stockés dans de multiples cavités (74) formées dans la bande de transport (78) ;
pour chacun de ces multiples supports (60), il existe un chemin de composant sur bande respectif (70) permettant de guider lesdits composants sur bande (58) qui sont tirés hors du support correspondant (60) parmi lesdits multiples supports (60) vers une position (90) de fourniture de composant électronique, lesdites multiples positions de fourniture (90) étant agencées parallèlement les unes aux autres et le long de lignes droites s'étendant dans une direction perpendiculaire à la direction d'indexage desdits composants sur bande (58) et ne se chevauchant pas dans la direction d'indexage desdits composants sur bande (58) ;
pour chacun de ces multiples chemins de composant sur bande (70), il existe un dispositif d'indexage respectif (72) permettant d'indexer lesdits composants sur bande (58) qui sont tirés hors du chemin de composant sur bande correspondant (70) parmi lesdits multiples chemins de composant sur bande (70) vers ladite position de fourniture (90), et
un panneau de commande (130) sur lequel se trouvent :
a) de multiples commutateurs de commande individuels (138, 140) permettant de commander individuellement l'élément correspondant parmi les multiples composants sur bande (58) qui sont tirés hors desdits multiples chemins de composant sur bande (70) et
b) de multiples symboles (143) sont affichés pour indiquer à quel élément chacun de ces multiples commutateurs de commande individuels (138, 140) correspond parmi lesdits multiples composants sur bande (58) ; lesdits multiples symboles (143) étant affichés sur ledit panneau de commande en suivant le même schéma que le schéma d'agencement desdites multiples positions de fourniture (90).

2. Dispositif d'alimentation à bande selon la revendication 1, dans lequel lesdits multiples commutateurs de commande individuels (138, 140) et symboles (143) sont disposés dans de multiples zones de commutateur de commande individuelles (136) qui sont agencées en grille sur ledit panneau de commande (130).
